# EUROPÄISCHE PATENTANMELDUNG

(11) **EP 1 318 532 A1**
(43) Veröffentlichungstag der Anmeldung: **11.06.2003**
(21) Anmeldenummer: 02027337.1
(22) Anmeldetag: 07.12.2002
(51) Int. Cl.: H01F 41/04, G06K 19/077, H05K 3/20

(54) **Spulenanordnung und Verfahren zu ihrer Herstellung**

(30) Priorität: 10.12.2001 DE 10160390
(71) Anmelder: cubit electronics Gmbh, 99099 Erfurt (DE); Michalk, Martin, 99092 Erfurt (DE)
(72) Erfinder: Michalk, Martin, 99092 Erfurt (DE); Michalk, Manfred, Dr., 99096 Erfurt (DE)
(74) Vertreter: Liedtke, Klaus, Dr.

(57) **Zusammenfassung**

2.1 Der Erfindung liegt die Aufgabe zugrunde, ein Verfahren und eine Spulendrahtanordnung vorzuschlagen, mit deren Hilfe mindestens temporär formstabile, einfach hantierbare Spulen herzustellen, zu Kontaktieren und als Schaltung auf Trageschichten zu fixieren, insbesondere ein vereinfachtes Verfahren zur Herstellung von kontaktlosen Transpondern anzugeben.
2.2 Erfindungsgemäß gelingt die Lösung der Aufgabe dadurch, dass während oder nach dem Erzeugen der Windungen mindestens zwei Windungen untereinander partiell an diskreten Stellen fixiert werden und dass der zu einer Spule geformte Wickeldraht partiell auf einer Trageschicht mittels einer aufgebrachten Haftklebeschicht fixiert wird.
2.3 Die Erfindung betrifft ein Verfahren zur Herstellung von mindestens temporär selbsttragenden Spulen für elektronische Schaltungen, wobei die Spulen zunächst in einem Wickelwerkzeug gewickelt und danach auf oder in eine Trägeranordnung gebracht werden und eine Spulenanordnung.

## Beschreibung

Die Erfindung betrifft ein Verfahren zur Herstellung von mindestens temporär selbsttragenden Spulen für elektronische Schaltungen, wobei die Spulen zunächst in einem Wickelwerkzeug gewickelt und danach auf oder in eine Trägeranordnung gebracht werden und eine Spulenanordnung.

Die Erfindung ist vorzugsweise für kontaktlose Transponder mit einer Antennenspule sowie für beliebige elektronische Schaltungen mit flachen Spulen einsetzbar.

Als kontaktlose Transponder werden dabei insbesondere kontaktlose Chipkarten mit einer Antennenspule und einem Chipmodul, Waren oder Warenverpackungen mit eingearbeiteten Antennen und Transponderchip, elektronische kontaktlose Etiketten, Tickets, Wertscheine etc. verstanden.

Im Stand der Technik sind mehrere Verfahren zur Herstellung mindestens temporär formstabiler, selbsttragender lackisolierter Spulen bekannt. Grundlage aller Verfahren ist ein Spulendraht, der zwei Isolierlackschichten trägt.

Eine Kemlackschicht, die direkt auf dem Metalldraht angebracht ist, deren thermische und chemische Beschaffenheit so zu wählen ist, dass sie unter den Belastungen bei Herstellung und Nutzung der Spule keine signifikanten Änderungen erfährt. Darüber befindet sich eine Backlackschicht, die sich unter thermischer und/oder chemischer Einwirkung mit den Backlackschichten benachbarter, anliegender Drahtwindungen verbindet.

Für flache Spulen, insbesondere für Spulen, die als Antennen für kontaktlose Transponder/Chipkarten verwendbar sind, wird das Verfahren des thermischen Verbackens der äußeren Isolierlackschichten der Drähte benutzt. Dazu ist es erforderlich, die einzelnen Lagen/Windungen der Drahtspule sehr straff übereinander und/oder nebeneinander zu wickeln unter gleichzeitiger Erwärmung des sich drehenden Wickelwerkzeuges mittels Heißluft. Insbesondere ist dabei der Spulendraht aufzuheizen. Eine bestimmte Temperatur des Wickelwerkzeuges muss jedoch eingehalten werden, um eine annähernd brauchbare Fixierung der Drähte untereinander zu erzielen.

Nach dem Drahtwickeln ist wiederum eine Abkühlphase notwendig, um die Backisolierschicht des Backlackes unter ihren Erweichungspunkt abzukühlen.

Nachteilig bei diesem Verfahren, das in DE 44 08 124 A1 und DE 196 34 661 A1 beschrieben ist, sind
- der Zeitaufwand für Erhitzen und Abkühlen von Wickelwerkzeug und Draht,
- das ungleichmäßige Verbacken der Drähte bei Rechteckspulen,
- die Verwindung flacher, insbesondere rechteckiger Spulen, da wegen des erforderlichen Anpressdruckes von Draht zu Draht die Drähte mit hoher Zugspannung zu wickeln sind, und die Spulendrähte insbesondere an den Spulenecken aus der Ebene wandern/klettern.

Weiterhin ist in DE 195 25 933 A1 ein Verfahren beschrieben, nachdem die gewickelte Spule mittels einer Seite des Wickelwerkzeuges thermisch auf einer thermoplastischen Folie fixiert wird. Nachteilig ist hierbei, dass nichtverbackene Spulenwindungen so nicht transportierbar sind bzw. das verbackene Spulen aufgrund der hohen Eigenspannungen sich vom schmalen Kern der Wickelmatritze trotz Vakuumansaugung drehen.

In DE 199 20 399 A1 wird vorgeschlagen, den Draht zu einer Spule zu spannen/zu wickeln und danach in oder auf der Oberfläche einer thermoplastischen Folie thermisch zu fixieren. Bei diesem Verfahren ist nachteilig, dass der Wickelvorgang und der Transfer- und Fixiervorgang mit einem Spannwerkzeug nacheinander erfolgen und dass aufgrund der Vielzahl der notwendigen Spannelemente Spulen mit mehr als 8 Windungen schwierig herstellbar sind.

Der Erfindung liegt die Aufgabe zugrunde ein Verfahren und eine Spulendrahtanordnung vorzuschlagen, mit deren Hilfe mindestens temporär formstabile, einfach hantierbare Spulen herzustellen, zu Kontaktieren und als Schaltung auf Trageschichten zu fixieren, insbesondere ein vereinfachtes Verfahren zur Herstellung von kontaktlosen Transpondern anzugeben.

Die Aufgabe wird erfindungsgemäß mit einem Verfahren, welches die im Patentanspruch 1 angegebenen Merkmale aufweist und einer Anordnung, welche die in Anspruch 11 angegebenen Merkmale aufweist, gelöst.

Vorteilhafte Ausgestaltungen sind in den Unteransprüchen angegeben.

Bei dem erfindungsgemäßen Vorgehen werden mindestens zwei Windungen oder zunächst in einem Wickelwerkzeug gewickelt, danach werden die thermoplastischen lackisolierten Drähte an bestimmten vorgesehenen Stellen untereinander fixiert, so dass die aus wenigstens zwei Windungen bestehende Spule insgesamt mindestens temporär für weitere Handlungsprozesse formstabil ist. Das Verfahren kann sequentiell gestaltet werden, indem die jeweils gewickelte Windung an die vorher gewickelte partiell angeheftet wird.

Die Erfindung zeichnet sich durch eine Reihe von Vorteilen aus
- Das Verfahren ermöglicht eine sichere Fixierung der Windungen untereinander.
- Die Herstellung der Spulen erfolgt in einem kostengünstigen und sehr produktiven Verfahren.
- Es kann Spulendraht mit nur einer einfachen Isolierlackschicht verwendet werden.
- Die Spulen können auf einfache Weise mit mindestens einem elektronischen Bauelement kontaktiert werden.
- Die Spulen können allein oder mit elektronischen Bauelementen kontaktiert auf einer oder zwischen mehreren Trageschichten. fixiert werden.
- Es ist nur ein geringer Drahtzug beim Wickeln erforderlich, so dass in der Spule hat fast keine Eigenspannungen auftreten.
- Die Fixierung erfolgt innerhalb kürzester Zeit, nämlich innerhalb von Millisekunden.
- Es sind keine Abkühlwartezeiten oder Wickelwerkzeugtemperierung erforderlich.
- Das Verkleben der Lackschichten mit dem Wickelwerkzeug wird vermieden.
- Es können Flachspulen mit Verzweigungen und Zusammenführungen hergestellt werden.
- Das Fixieren eines Moduls am Spulendraht zur Herstellung eines formstabilen Spulen-Modul-Verbundes ist möglich.
- Das Fixieren einer mit einem Modul kontaktierten Spule auf einer Trageschicht kann mittels Haftkleber oder mittels thermischen Klebens ohne Hilfsmaterial vorgenommen werden.

Besonders vorteilhaft ist das Verfahren für Spulen anzuwenden, die als eine Drahtstärke dicke Flachspule, also Draht auf Draht oder eine eindrahtige Hohlspule, zu wickeln sind. Das Wickelwerkzeug weist für eine Flachspule zumindestens an der Wickelkernplatte und/oder an der Wickelplatte, die parallel zueinander mit Wickeldrahtabstand angeordnet sind, Durchbrüche auf, die jeweils einen Teil der Spulenfläche freigeben. Durch diese Durchbrüche werden die zu verbindenden Wickeldrahtabschnitte der Spule zugänglich gemacht. Die nur abschnittweise, also partielle Fixierung der Spulendrähte untereinander kann durch zeitlich, intensitätsmäßig und örtlich gesteuertem Energieeintrag und damit verbundenes Aufschmelzen und Verschmelzen der Thermoplastlackschichten der Wickeldrähte erfolgen, oder der Energieeintrag kann über Wärmeleitung durch heiße Druckstücke oder durch heiße, stark lokalisierte Gasströme erfolgen. Eine weitere Möglichkeit der partiellen Fixierung der Spulenabschnitte besteht im Auftrag und Aufschmelzen oder Aushärten von additiven Klebern, wobei das Härten wiederum durch energiereiche Strahlung (Licht; UV-Licht) oder durch Wärmezufuhr etc. beschleunigt werden kann. Der Kleberauftrag kann durch tintenstahlerähnliche Düsen erfolgen.

Geschieht die Wickeldrahtfixierung untereinander durch Strahlung, so ist vorteilhaft Laserlicht anzuwenden. Das Aufschmelzen und Verschmelzen der Lackschichten erfolgt in extrem kurzer Zeit. Da sich dabei die Lackschichten z. T. aufblähen, ist auch ohne signifikanten Druck der Wickeldrähte untereinander das Berühren und Verschmelzen der thermoplastischen Lackschichten gegeben.

Da sich außer den Lackschichten weder Wickelwerkzeug noch der metallische Draht (außer gegebenenfalls in den bestrahlten Randflächen) selbst nennenswert erwärmen, erstarrt die Lackschmelze sofort nach Abschalten der Energiestrahlung und die Spulendrähte untereinander bzw. die Spulen sind je nach Geometrie der Durchbrüche, des Laserstrahlquerschnittes und der Strahlenbewegung punkt-, linien- oder flächenweise untereinander fixiert.

Die die Drähte in den nichtbestrahlten Bereichen durch die nicht aufgeschmolzenen Lackschichten auf Distanz gehalten werden, ist ein eventueller Kurzschluss von Wicklungen untereinander aufgrund eventueller, zeitweilig aufgeschmolzener Kernlackschichten nicht zu befürchten.

Es ist vorteilhaft mehrere Wickelkerne im Wickelwerkzeug anzuordnen, wobei mindestens ein Wickelkern in die bzw. aus der Wickelkammer einschiebbar oder ausziehbar ist. Werden Kerne während des Wickelns zusätzlich eingeschoben, müssen die nachfolgend aufzuwickelnden Windungen ein anderen, weiteren Umlaufweg nehmen als die bereits aufgewickelten Windungen. Es entstehen Flachspulen, die zwischen den Spulenwindungen mindestens eine wickeldrahtfreie Zone aufweisen. In diese Zone können elektronische Bauelemente bzw. Halbleiterchips enthaltende Module eingesetzt werden, deren Anschlüsse z.B. mit den Spulenanschlüssen verbunden werden.

Bedingt durch die während des Wickelvorganges zusätzlich eingeschobenen Kerne, entstehen Verzweigungen bestimmter Wicklungsabschnitte bzw. es entstehen Zusammenführungen der Drähte in bestimmten Wicklungsabschnitten.

Zur Gewährleistung der Spulenformstabilität ist es erforderlich die Spulendrähte unmittelbar vor den Verzweigungen bzw. nach den Zusammenführungen partiell zu fixieren/verbacken.

Vorteilhaft ist hierbei, dass die Spule und zu kontaktierende elektronische Bauelemente (z. B. Halbleiterchip) eine besonders flache Einheit ergeben, da das Chip mechanisch geschützt in der wickeldrahtfreien Zone liegt.

Weiterhin ist es zweckmäßig die Wickeldrähte an den künftigen Kontaktzonen vor der Kontaktierung mit dem Kontaktierbereich des Moduls abzuisolieren bzw. die Isolierdicke signifikant zu verringern.. Vorteilhaft geschieht das durch energiereiche Licht- bzw. Laserstrahlung.

Weiterhin vorteilhaft ist es, die sich noch in den Wickelwerkzeug befindliche Spule mit dem Modul zu verbinden. Das auf einem Modulhalter befindliche Modul wird über den im Wickelwerkzeug befindlichen Moduldurchbruch der Spule zugeführt, so dass die Kontaktierungszonen der Spule direkt auf den Kontaktierbereichen der Modulabschlüsse aufliegen. Der Elementbereich des Moduls liegt in der wickeldrahtfreien Zone der Spule.

Spulenwindungen verlaufen über Modulanschlüsse und über leiterdrahtfreie, isolierende Bereiche der Modulanschlüsse.

Der Kontaktiervorgang selbst kann durch Thermokompression, Spaltschweißen, Löten, Kleben o. a. Vorgänge erfolgen.

Vorteilhaft ist es, mindestens eine Spulenwindung, die über die Modulanschlüsse verläuft auf dem isolierenden Bereich der Modulanschlüsse mechanisch zu fixieren. Damit erlangt die mit dem Modul kontaktierte Spule eine höhere mechanische Stabilität in Bezug auf die weiteren Ablage- bzw. Übergabevorgänge.

Vorteilhaft ist es, das Isoliermaterial des Modulanschlusses so zu wählen, dass Laserlicht kurzer Wellenlänge nicht absorbiert wird. Beim Bestrahlen des leiterbahnfreien Modulanschlussbereiches von seiner Rückseite her mit Laserlicht kurzer Wellenlänge (≤ 1,5 µm) dringt das Laserlicht durch den Modulanschluss und die Isolierschicht der darüber gespannten Drahtwindung, erhitzt den Draht, so dass die Isolierschicht des Drahtes aufschmelzen und sich mit dem Modulanschluss verbinden kann.

Es ist vorteilhaft den Draht dabei gegen den Modulanschluss zu drücken.

Vorteilhaft ist es weiterhin, das Isoliermaterial des Modulanschlusses so zu wählen, dass Laserlicht langer Wellenlänge (etwa 10 µm) absorbiert wird. Dies ermöglicht das Aufschmelzen der Isolierschicht des Drahtes ohne den Metallkern des Drahtes zu erhitzen.

Die kontaktierte Spule kann, wie bereits im Stand der Technik beschrieben, auf selbstklebenden Haftkleberschichten fixiert werden. Der Spulentransfer kann, wie im Stand der Technik beschrieben durch direktes Aufsetzen der Wickelwerkzeugkernplatte mit einer Anzahl von durch den Aufsetzdruck zurückgeschobenen, die Spule freigebenden stiftförmigen Wickelkernen auf die Haftklebefolie erfolgen. Vorteilhaft ist es, die Wickelwerkzeugkernplatte so auszuführen, dass mindestens im Bereich der Verbackungszonen der Spulendrähte Ansauglöcher angeordnet sind und so die Spule nach Abnehmen der Wickelplatte bis zum Fixieren auf einer Trageschicht durch Ansaugen bzw. Vakuum an der Wickelkernplatte gehalten wird.

Ein weiteres vorteilhaftes Verfahren der Spulenfixierung auf einer haftkleberfreien Trageschicht besteht darin, dass die Trageschicht Laserlicht kurzer Wellenlänge (ca. 1 µm) oder langer Wellenlängen (ca. 10 µm) nicht signifikant absorbiert, jedoch die auf die Trageschicht gedrückten/gepressten Spulendrähte so erwärmt werden, dass durch langwelliges Laserlicht die Isolierlackschicht direkt oder die Isolierlackschicht und/oder Bereiche der Trageschicht durch die erhitzten Drähte angeschmolzen werden, so dass sich Isolierlackschicht und Trageschicht im mit Laserlicht bestrahlten Bereich verbinden.

Weiterhin ist es vorteilhaft die kontaktierte Spule aus dem Wickelwerkzeug zu entnehmen und sie durch eine weitere Handlings- und Andrückvorrichtung auf die Trageschicht zu transferieren und mit Haftkleber oder bei geeigneter Trageschichtmaterialausführung mittels von der Trageschichtrückseite eingestrahlter Laserlichtenergie zu fixieren.

Die Erfindung wird nachfolgend anhand eines Beispiels näher erläutert.

### In den zugehörigen Zeichnungen zeigen:

- Figur 1: eine Wickelkernplatte in Draufsicht,
- Figur 2: eine Wickelplatte in Draufsicht,
- Figur 3: ein Wickelwerkzeug mit innenliegender Spule in Draufsicht,
- Figur 4: einen partiell fixierten Drahtspulenabschnitt in Draufsicht,
- Figur 5: eine Wickelkernplatte mit verzweigter Spule in Draufsicht,
- Figur 6: ein Modul in Draufsicht,
- Figur 7: eine Spule mit kontaktiertem Modul in Draufsicht,
- Figur 8: ein Spule in Trageschicht in geschnittener Seitenansicht, und
- Figur 9: ein haftklebebeschichtete Trageschicht mit fixierter Spule in geschnittener Seitenansicht.

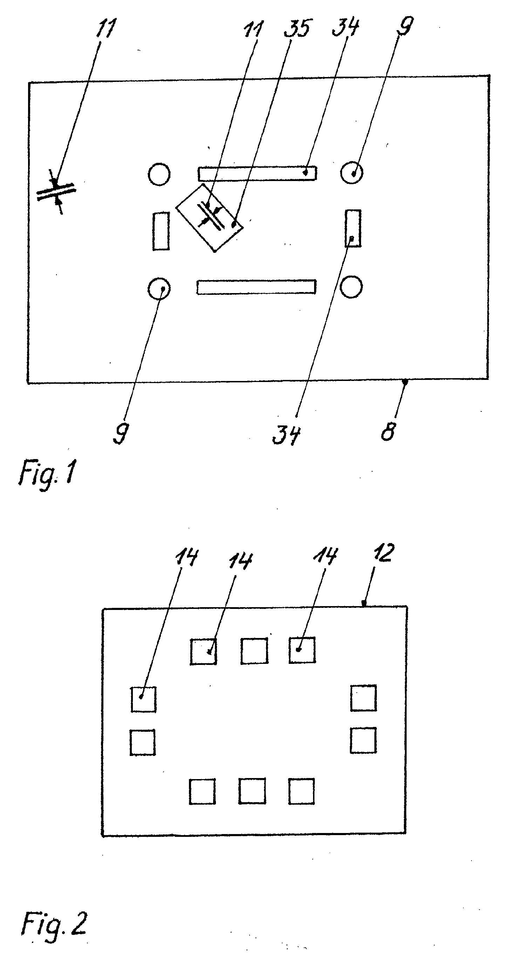

**Figur 1** zeigt eine Wickelkernplatte 8 in der Ausführung für eine rechteckige Spule 26. Die Spule 26 soll als Flachspule so gewickelt werden, dass Wickeldraht 1 auf Wickeldraht 1 liegt, die Spule 26 ist demnach genau einen Wickeldrahtdurchmesser dick.

Die Abstandshalter 34 halten Wickelkernplatte 8 und Wickelplatte 12 in einem solchen Abstand, dass nur Wickeldraht 1 über Wickeldraht 1 gelegt werden kann.

Die Wickelkerne 9 sind axial beweglich. In einer Freimachung 35 im Zentrum der Wickelkernplatte 8 befindet sich eine Drahtklemme 11, die den Drahtanfang zangenartig festhält. Eine weitere Drahtklemme 11 befindet sich an der Peripherie der Wickelplatte 8, die den Wickeldraht 1 am Spulenende festhält.

Die Wickelplatte 12 in **Figur 2** weist Durchbrüche 14 auf, die partiell die Wickelbahn der zu wickelnden Spule 26 freigeben.

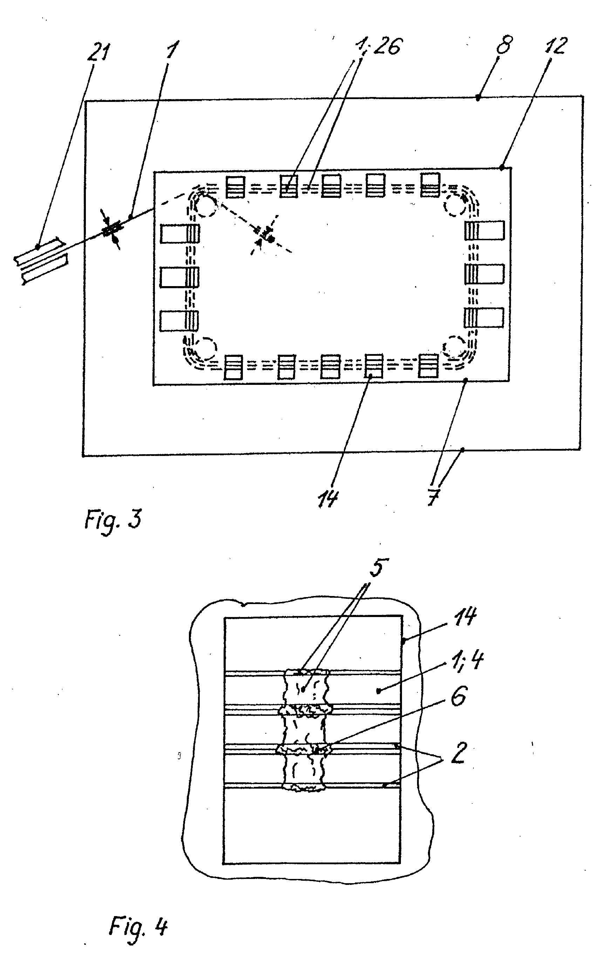

In **Figur 3** ist die Wickelplatte 12 auf die Wickelkernplatte 8 planparallel aufgedrückt. Die im Beispiel 100 µm dicken Abstandhalter 34 halten den Wickelspalt im Wickelwerkzeug 7 frei. Die Wickelkerne 9 sind bis an die Wickelplatte 12 heran geschoben. Der Wickeldraht 1, der im Beispiel eine Kernlackschicht trägt, wobei der Drahtdurchmesser 70 µm und der thermoplastische Kernlack 2 eine Schichtdicke von 7 µm aufweist, ist insgesamt 84 µm dick.

Die Drahtführungseinrichtung 21 führt den Wickeldraht 1 noch bei geöffneten Wickelwerkzeug 7 in die im Zentrum befindliche Drahtklemme 11 ein. Nach Schließen des Wickelwerkzeuges 7 dreht sich im Beispiel die Vorrichtung 21 fünf mal in der Wickelebene um das Wickelwerkzeug 7 unter Bildung einer Spule 26, führt danach dem Wickeldraht 1 über bzw. in die periphere Drahtklemme 11. Durch Klemmenschluss wird das Spulenende ebenfalls festgeklemmt.

In **Figur 4** ist vergrößert dargestellt ein im Durchbruch 14 sichtbarer Spulenabschnitt nach dem partiellen Fixieren der Wickeldrähte 1 untereinander.

Mittels langwelliger Laserstrahlung, im Beispiel ein CO₂-Laser und schreibender Laserstrahlführung ist eine ca. 300 µm breite, quer zur Drahtrichtung verlaufende Spur bestrahlt worden. Durch die Laserstrahlung schmolz die Kernlackschicht 2 auf, dehnt sich dabei aus und verschmolz mit der ebenfalls aufgeschmolzenen Kernlackschicht 2 der benachbarten Wickeldrähte 1 und bilden eine Benetzungszone 6.

Durch die sehr kurze, intensive Laserstrahlung können im Kernlack 2 Gase freigesetzt werden, die das aufgeschmolzene Volumen des Kernlackes 2 zusätzlich vergrößern. Da keine signifikante Erwärmung des 70 µm dicken Kupferdrahtes 1 auftritt, erstarren unmittelbar nach Abschalten oder Weiterführen des Laserstrahl die verschmolzenen Kernlackbereiche 5; 6, die Spule 26 ist partiell fixiert.

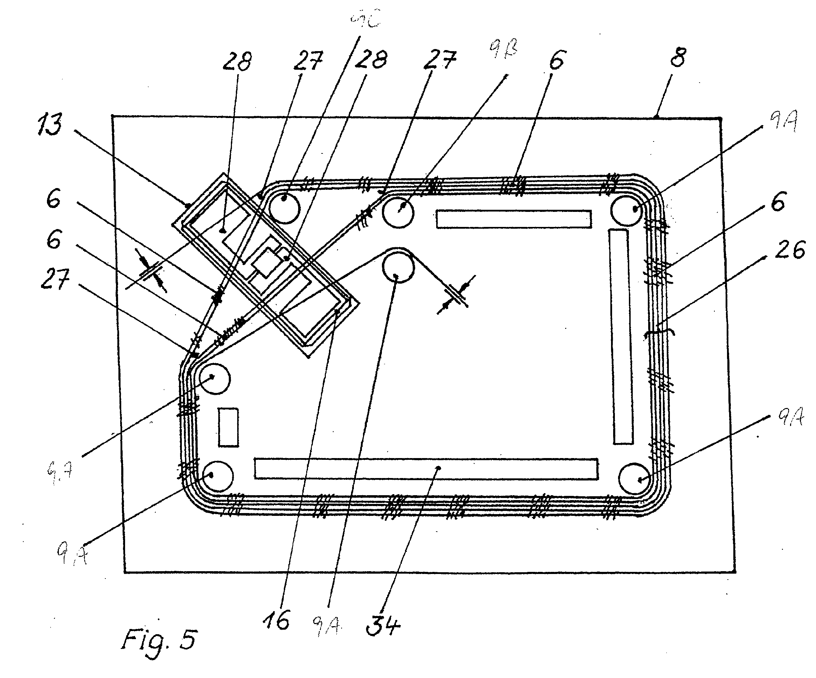

In **Figur 5** lagen nach Klemmen des Wickeldrahtes 1 bzw. des Spulenanfanges im Zentrum der Wickelkernplatte 8 und nach Schließen des Wickelwerkzeuges 7 nur die Wickelkerne 9 an der Wickelplatte 12 an.

Erst nach Wickeln einer Spulenwindung wurde der Wickelkern 9 in den Wickelspalt geschoben, nach 2 weiteren Spulenwindungen wurde der Wickelkern 9 in den Wickelspalt geschoben. Schließlich führt die in Figur 5 nicht gezeigte Drahtführungseinrichtung 21 den Wickeldraht 1 seitlich schräg über bzw. in die periphere Drahtklemme 11 ein. Durch das von der Windungszahl abhängige, nacheinander erfolgende Einführen der Wickelkerne 9 in den Wickelspalt des Wickelwerkzeuges 7 ergab sich eine Spule 26, die Verzweigungen 27 und Zusammenführungen 27 von Drahtwindungen aufweist.

Zur Sicherung der Formstabilität dieser flachen Spule 26 ist es erforderlich, insbesondere kurz vor den Verzweigungen 27 bzw. kurz nach den Zusammenführungen 27 die Wickeldrähte 1 untereinander partiell zu fixieren. Durch die Spulenverzweigungen 27 ergeben sich wickeldrahtfreie Zonen 28.

Nach dem Abheben der Wickelplatte 12 von der Wickelkernplatte 8, das heißt nach dem vollständigen Öffnen des Wickelwerkzeuges 7 und nach dem Kontaktieren des Moduls 16 an die vorgesehenen Spulenanschlussbereiche ergibt sich endgültig die Darstellung in Figur 5.

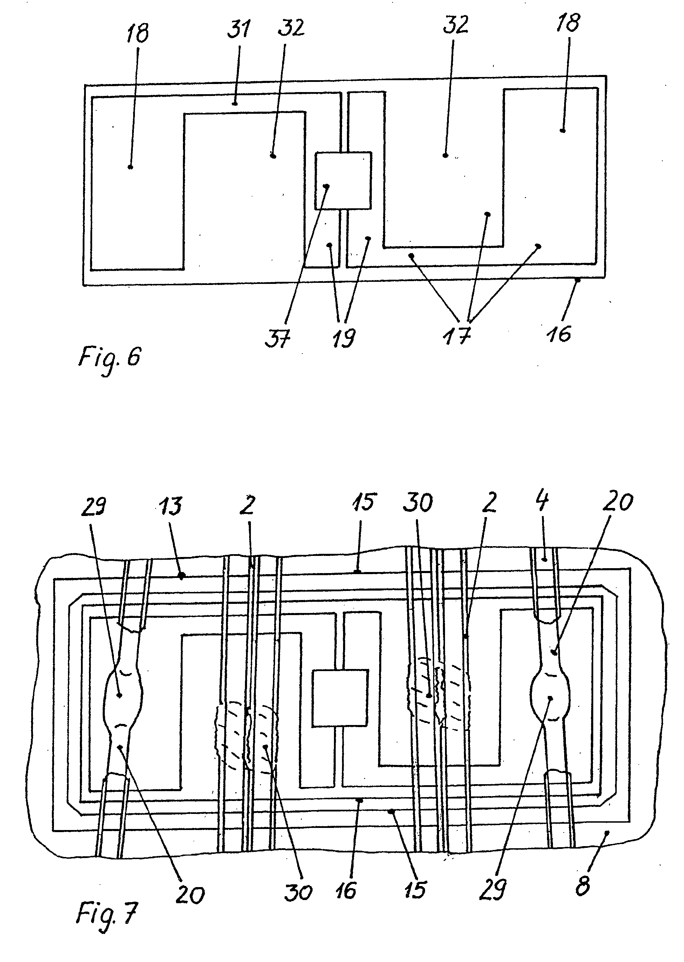

**Figur 6** zeigt ein Modul 16, bestehend aus einem länglichen flächenförmigen thermoplastischen Folienstück aus elektrischen isolierendem Material 36, auf dem Isoliermaterial 36 der Größe (3 x 14) mm² und der Dicke von 50 µm befindet sich eine 18 µm dicke folienförmige Kupferstruktur. Der flächenmittige Elementbereich 18 dient der Kontaktierung des Halbleiterchips 37, beidseitig schließen sich die Modulanschlüsse 17 an, die an beiden Modulenden Kontaktierbereiche 18 der Größe (2,5 x 2,5 ) mm² aufweisen. Kontaktierbereiche 18 und Elementbereiche 19 sind durch 100 µm breite Leiterbahnen 31 verbunden, so dass sich auf den Modulanschlüssen 17 zwischen Kontaktierbereich 18 und Elementbereich 19 große leiterbahnfreie, elektrisch isolierende Bereiche 32 befinden.

Die Unterseite des Isoliermaterials 36 bildet die Rückseite 33 des Moduls 16.

**Figur 7** zeigt in starker Vergrößerung das gemäß Figur 5 an die Spulenenden, in Figur 6 detailliert dargestellte Modul 16. Das Modul 16 liegt mit seiner Rückseite 33 auf dem Modulhalter 15, der mindestens in den leiterbahnfreien Bereichen 32 des Moduls 16 laserlichtdurchlässig ist. Modulhalter 15 mit den durch Vakuum angesaugten Modul 16 befindet sich im Moduldurchbruch 13 der Wickelkernplatte 8 in einer solchen Lage, dass die über den Moduldurchbruch 13 gespannten Wickeldrähte 1 auf der Kupferstruktur 30; 31 bzw. auf dem leiterbahnfreien Bereich 32 aufliegen.

Die über die Kontaktierbereiche 18 verlaufenden Wickeldrähte 1 weisen Entisolierzonen 20 auf, von denen die thermoplastische Isolierlackschicht 2 durch Strahlungsenergieeintrag mit einem CO₂-Laser weitgehend entfernt bzw. abladiert worden ist. Mittels nicht näher beschriebenen Thermokompressionsverfahren sind die entisolierten Wickeldrähte 1 an die Kontaktierbereiche 18 geschweißt und sie bilden eine Kontaktierung 29 in Form einer Diffüsionsschweißung bzw. bei Verwendung silberbeschichteter Kontaktierbereiche 18 in Form einer Hartlötung aus.

Die weiteren Spulenwindungen verlaufen derart, dass zwei Windungsabschnitte über die Modulanschlüsse 17 im leiterbahnfreien Bereich 32 verlaufen, so dass einerseits das Halbleiterchip 37 zwischen den Spulenwindungen liegt und andererseits diese Spulenwindungsabschnitte einen technologisch ausreichenden Abstand zu den Kontaktierbereichen 18 aufweisen.

Durch im Beispiel Laserstrahlung der Wellenlänge von 800 nm ... 1000 nm durch den Modulhalter 15 im Bereich der leiterbahnfreien Bereiche 32 des Moduls 16 wird die äußere Kupferschicht 1 des Wickeldrahtes erhitzt, so dass durch die Energieeinleitung die thermoplastische Kernlackschicht 2 kurzzeitig aufschmilzt und die Wickeldrähte 1 im bestrahlten Abschnitt über die wieder erstarrte Lackschicht 2 mit dem thermoplastischen Isoliermaterial 36 im Bereich der Kontaktzone 30 mit den leiterbahnfreien Bereichen 32 der Modulanschlüsse 17 formstabil verbindet.

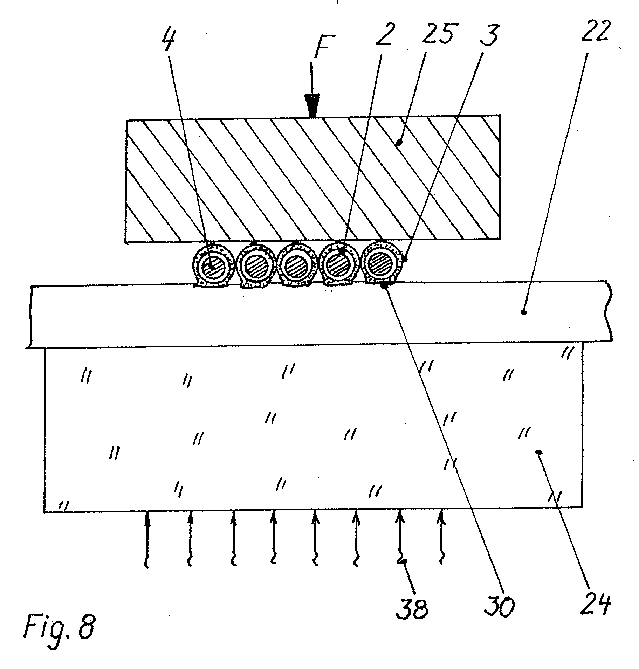

In **Figur 8** ist ein Querschnitt durch einen bestimmten Bereich einer Spule 26 gezeigt, deren Wickeldrähte 1 sowohl einen Kernlackschicht 2 als auch eine thermoplastische Backlackschicht 3 aufweisen. Die Spule 26 und das ankontaktierte Modul 16 sind von der Wickelkernplattte 8 unter Zurückziehung der Wickelkerne 9 frei gegeben und auf die Trageschicht 22, auf die die Spule 26 zu heften ist, aufgelegt worden. Die Trageschicht 22 liegt auf einer für Laserstrahlung durchlässigen Auflagefläche 24, die als Amboss dient, auf. Eine Andrückplatte 25 drückt die Spule 26 planparallel gegen die Trageschicht 22 und deren Auflagefläche 24.

Durch kurzzeitige Bestrahlung mit energieintensivem Laserlicht der Wellenlänge 800 nm ... 100 nm im Beispiel erhitzen sich die Kupferdrähte 1 auf der bestrahlte Seite und schmelzen durch Wärmeübergabe mindestens die Backlackschicht 3 und gegebenenfalls die thermoplastische Trageschicht 22, die ebenfalls für Laserlicht oben genannter Wellenlänge lichtdurchlässig ist, auf. Nach Abbruch der Bestrahlung haftet die Spule 26 im bestrahlten Bereich die aufgeschmolzene und wieder erstarrte Backlackschicht 3 bildet mit der Trageschicht 22.

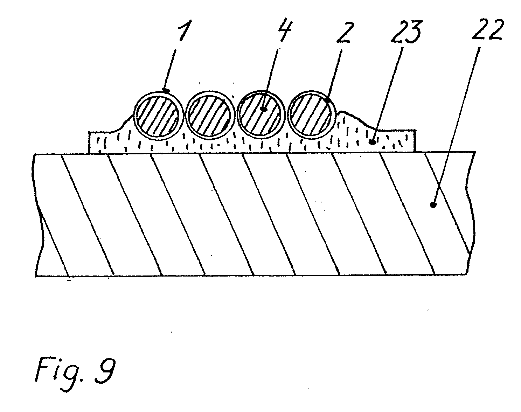

**Figur 9** stellt die Fixierung der Spule 26 auf einer partiell auf eine Trageschicht 22 aufgebrachten Haftklebeschicht 23 dar. Die Wickeldrähte 1 besitzen im Beispiel nur eine Kernlackschicht 2. Die Dicke der Haftklebeschicht 23 beträgt 40 ... 50 nm.

### BEZUGSZEICHENLISTE

- 1: Wickeldraht
- 2: Kernlackschicht
- 3: Backlackschicht
- 4: Draht
- 5: aufgeschmolzene Lackschicht
- 6: Kleberkontakt; Benetzungszone, Verschmelzungszone
- 7: Wickelwerkzeug
- 8: Wickelkernplatte
- 9: Wickelkern
- 10: Wickelkernantrieb
- 11: Drahtklemme
- 12: Wickelplatte
- 13: Durchbruch für Modul
- 14: Durchbruch für Spulenabschnitt
- 15: Modulhalter
- 16: Modul
- 17: Modulanschluss
- 18: Kontaktierbereich
- 19: Elementbereich
- 20: Entisolierzone
- 21: Drahtführungseinrichtung
- 22: Trageschicht
- 23: Haftklebeschicht
- 24: Auflagefläche
- 25: Andrückplatte
- 26: Spule
- 27: Verzweigung, Zusammenführung
- 28: wickeldrahtfreie Zone
- 29: Kontaktierung

- 30: Kontaktzone
- 31: Leiterbahn (auf Modulanschluss)
- 32: leiterbahnfreier Bereich des Moduls
- 33: Rückseite Modul
- 34: Abstandshalter
- 35: Drahtklemmenfreimachung
- 36: Isoliermaterial
- 37: Halbleiterchip
- 38: Strahlung

## Patentansprüche

1. Verfahren zur Herstellung von mindestens temporär selbsttragenden Spulen (26) für elektronische Schaltungen, wobei die Spulen (26) zunächst in einem Wickelwerkzeug (7) gewickelt und danach auf oder in eine Trägeranordnung gebracht werden, **dadurch gekennzeichnet, dass** während oder nach dem Erzeugen der Windungen mindestens zwei Windungen untereinander partiell an diskreten Stellen fixiert werden.

2. Verfahren nach Anspruch 1, **dadurch gekennzeichnet, dass** das Fixieren durch Kleberauftrag erfolgt und der Kleber durch Einwirkung von Wärme, Zeit und/oder Licht gehärtet wird.

3. Verfahren nach Anspruch 1, **dadurch gekennzeichnet, dass** das Fixieren durch Einwirkung von hochenergetischen Licht erfolgt, mit dem ein Verbacken des Isolierlacks erzeugt wird.

4. Verfahren nach Anspruch 3, **dadurch gekennzeichnet, dass** das Verbacken durch Einwirkung von Licht einer Wellenlänge größer 5 µm erfolgt

5. Verfahren nach Anspruch 3, **dadurch gekennzeichnet, dass** das Verbacken durch Erwärmen des Wickeldrahtes (1) und damit indirektes Erwärmen der Isolierschicht durch Einwirkung von Licht einer Wellenlänge kleiner 5 µm erfolgt.

6. Verfahren nach einem der vorhergehenden Ansprüche, **dadurch gekennzeichnet, dass** das Wickeln auf einem Wickelwerkzeug (7) erfolgt, welches zumindestens an einer Wickelkernplatte (8) oder einer Wickelplatte (12), die parallel zueinander im Wickeldrahtabstand angeordnet sind, Durchbrüche aufweist, durch die bewegliche Wickelkerne (9) ein- und ausgeschoben werden können und die jeweils einem Teil der Spulenfläche freigeben.

7. Verfahren nach einem der vorhergehenden Ansprüche, **dadurch gekennzeichnet, dass** durch Einschieben zusätzlicher Wickelkerne (9) Verzweigungen (27) der Spulenanordnung erzeugt werden.

8. Verfahren nach Anspruch 7, **dadurch gekennzeichnet, dass** die Wickellagen untereinander an den Verzweigungsstellen (27) fixiert werden.

9. Verfahren nach Anspruch 7 oder 8, **dadurch gekennzeichnet, dass** der Wickeldraht (1) an leiterbahnfreien Bereichen (32) von Modulanschlüssen fixiert wird.

10. Verfahren nach einem der vorhergehenden Ansprüche, **dadurch gekennzeichnet, dass** vor dem Wickelvorgang das Wickelwerkzeug (7) und/oder der Wickeldraht (1) und/oder die Trägeranordnung vorgewärmt werden.

11. Verfahren nach einem der vorhergehenden Ansprüche, **dadurch gekennzeichnet, dass** der zu einer Spule (26) geformte Wickeldraht (1) partiell auf einer Trageschicht (22) mittels einer aufgebrachten Haftklebeschicht (23) fixiert wird.

12. Spulenanordnung für elektronische Schaltungen, die Spulen zunächst in einem Wickelwerkzeug (7) gewickelt und danach auf oder in eine Trägeranordnung gebracht werden kann, **dadurch gekennzeichnet, dass** mindestens zwei Windungen untereinander partiell an diskreten Stellen fixiert sind.

13. Kontaktloser Transponder, vorzugsweise kontaktlose Chipkarte, **dadurch gekennzeichnet, dass** der Transponder eine nach einem der Ansprüche 1 bis 11 hergestellte Spulenanordnung enthält.
